(19)

Europäisches
Patentamt

European
Patent Office

Office européen
des brevets

(11) **EP 3 007 200 A1**

(12) **EUROPEAN PATENT APPLICATION**

(43) Date of publication:
**13.04.2016 Bulletin 2016/15**

(51) Int Cl.:
***H01J 37/26*** *(2006.01)*

(21) Application number: **14187878.5**

(22) Date of filing: **07.10.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **FEI COMPANY
Hillsboro, Oregon 97124-5793 (US)**

(72) Inventors:
• **Buijsse, Bart
5646 JE Eindhoven (NL)**

• **Van Duinen, Gijs
3523 VW Utrecht (NL)**
• **Jonkers, Roland
5711 KV Someren (NL)**

(74) Representative: **Bakker, Hendrik
FEI Company
Patent Department
P.O. Box 1745
5602 BS  Eindhoven (NL)**

(54) **Conditioning of a hole-free phase plate in a TEM**

(57)    The invention relates to a method of conditioning a hole-free phase plate in a Transmission Electron Microscope (100), the method characterized by:
• define a sample spatial frequency range of interest, ranging from $F_{low}$ to $F_{high}$
• providing a sample (108) having at least an amorphous part in the sample plane,
• irradiating an amorphous part of the sample with the parallel beam, thus forming a diffraction pattern of the amorphous part of the sample on the phase plate,
• while irradiating the sample, repeatedly:
◦ record an image,
◦ estimate the sample spatial frequency dependent Radially Averaged Power Spectrum, RAPS(k), of the image
◦ estimate the integral of RAPS(k), $\int$RAPS(k)dk, integrated over the sample spatial frequency range of interest,

• until $\int$RAPS(k)dk is larger than a first predetermined value for $\int$RAPS(k)dk, in which case the irradiation is terminated and the conditioning is a successful conditioning, or
• until the conditioning takes too long or the change of $\int$RAPS(k)dk between successive images is below a predetermined minimum value, in which case the irradiation is terminated and the conditioning is an unsuccessful conditioning.

The invention describes a method for conditioning a so-called Volta phase plate, the method suited for automation and for reproducible results. Also, contrary to prior art methods, the invention results in an optimized contrast, instead of maximal phase shift.

FIG. 4

**EP 3 007 200 A1**

## Description

## Field of the invention

The invention relates to a method of conditioning a hole-free thin-film phase plate in a Transmission Electron Microscope (TEM), the TEM comprising:

- an electron source for producing a beam of electrons,
- a sample plane,
- a condenser system for forming a parallel or almost parallel beam of electrons on the sample plane,
- an objective lens for focusing the parallel or almost parallel beam at a diffraction plane,
- a hole-free thin-film phase plate positioned in the diffraction plane or a plane conjugated thereto,
- an imaging system for forming an enlarged image of the sample plane or the diffraction plane onto an image plane
- a detector in the image plane for recording images formed on the image plane.

## Background of the invention

In a Transmission Electron Microscope (TEM) a sample is imaged by passing a beam of energetic electrons with a selectable energy of, for example, between 40 keV and 400 keV, through the sample.

For so-called weak-phase samples, such as unstained biological samples, most electrons pass through the sample while some electrons are elastically or inelastically scattered, the elastically scattered electrons forming diffracted beams. The image is formed by interference of the elastically scattered and unscattered electrons (diffracted and undiffracted beams), or more precisely: the interference of the unscattered and scattered part of the wave function of an electron.

A problem arises in that the Contrast Transfer Function (CTF) for low spatial frequencies in the image is zero or close to zero, resulting in low visibility of large objects/structures. This is caused by the fact that phase variations induced by the specimen do not lead to intensity variations at the image plane for an in-focus aberration free imaging system. For higher spatial frequencies, lens aberrations can turn phase variations into intensity variations.

A solution to the poor contrast at low spatial frequencies is the use of a phase plate, the phase plate introducing a phase difference between the diffracted beams and the undiffracted beam. There are two main types of phase plates: the so-called Zernike phase plate leaves the undiffracted beam unchanged, and causes a phase shift of the diffracted beams, while the so-called Boersch phase plate shifts the undiffracted beam while leaving the diffracted beams unchanged.

When the phase shift introduced by the phase plate is approximately $+\pi/2$ or $-\pi/2$ the sine-like behavior of the CTF changes to a cosine-like behavior, and thus a maximum contrast (positive or negative) occurs for low spatial frequencies. For a more thorough description of phase plates and other contrast enhancing devices see Nagayama K et al., 'Phase Contrast Enhancement with Phase Plates in Biological Electron Microscopy', Microscopy Today, July 2010, Vol. 18, No. 4 (July 2010), pages 10-13, further referred to as Nagayama [-1-].

A problem of both Boersch phase plates and Zernike phase plates is that they require microscopic holes (typically less than 1 $\mu$m) for passing the undiffracted beam unhindered and a centering accuracy which is even an order of magnitude better than the hole size. This resulted in the development of self-centering phase plates, the so-called hole-free phase plates (HFPP).

A hole-free thin-film phase plate, further referred to as a HFPP, is first described by Johnson HM, 'Chapter 4: In-focus phase contrast electron microscopy', in 'Principles and Techniques of Electron Microscopy, Vol. 3: Biological applications', Ed. M.A. Hayat, ISBN-0-442-25674-4, pages 174-176, further referred to as Johnson [-2-].

The phase plate described in Johnson [-2-] is formed by a contamination spot on a continuous carbon film. This spot is formed using the electron beam in high current mode. The contamination spot modifies the thickness of the film, resulting in a thicker part. This film can then, at lower current, be used as a HFPP, where the undiffracted electrons, passing through the thick spot, experience a larger (negative) phase shift than the diffracted electrons passing through the non-contaminated (or less-contaminated) film. The effect of such a HFPP thus resembles the effect of Zernike phase plate, but with the difference that this phase plate gives a negative phase contrast.

An advantage of such a HFPP is that it is self-building and thus self-centered, as the contamination spot is formed by the beam being centered on the HFPP.

A disadvantage of this phase plate is that the build-up of contaminants (the thickness of the contaminated spot) is difficult to control, thus hampering practical use of the device.

It is noted that electrons travelling through a thin film experience a negative phase shift relative to electrons travelling the same distance in vacuum, as the material has a positive inner potential, thus accelerating the electrons inside the material. Electrons travelling in a material are thus advanced with respect to electrons that do not travel through the material, resulting in said negative phase shift. As this is often misunderstood, often the absolute phase shift $|\varphi|$ is referred to.

Another HFPP is known from US patent application No. US 2011/0174971A1 to Malac et al., further referred to as Malac, describing a thin film exposed to an electron beam, resulting in positive charging (due to secondary electron emission). Malac describes that during conditioning the CTF changes with time for an initial period of about 1 minute (for a gold thin film) to about 15 minutes (for a carbon thin film). After the initial period the CTF is unchanged, after which images can be taken (i.e.: the conditioning is ended).

A disadvantage of this phase plate is that finding the correct charging for an optimum CTF (or better, the absolute value of the CTF, |CTF|) is difficult, and results in hard to control operation: the steady state charging level (attainable by long exposure) need not correspond with the optimum value of the |CTF|.

Yet another type of HFPP is known from European patent application No. EP14165529A1 to Buijsse et al., further referred to as Buijsse. This application describes a so-called Volta phase plate where the electronic structure of the thin film is changed by irradiation with a focused beam of electrons, resulting in the local build-up of a vacuum potential. No method is given to determine the correct preparation/conditioning of the HFPP, resulting in the correct change in electronic structure.

It is noted that the HFPP described in Buijsse causes a positive phase contrast for low spatial frequencies, while the HFPPs described by Johnson [2] and Malac cause a negative phase contrast for low spatial frequencies. Therefore these two groups of HFPP's are from a different type.

It is noted that typically the person skilled in the art tries to illuminate the sample with a parallel beam of electrons, and the diffraction plane thus coincides with the back-focal plane of the objective lens. However, if the irradiating beam is not exactly a parallel beam, but is slightly converging or diverging, a diffraction plane is formed that slightly deviates from the back-focal plane. Said diffraction plane formed by a non-parallel beam is equally well suited as a diffraction plane formed by a parallel beam.

There is a need for a method to determine the correct preparation/conditioning of a HFPP. In particular, there is a need for an automated, reproducible method of conditioning of a HFPP.

It is an object of the invention to address these issues. More specifically, it is an object of the invention to provide an automated method of conditioning a HFPP.

**Summary of the invention**

These and other objects are achieved by the method as set forth in the opening paragraph above, the method further comprising:

- define a sample spatial frequency range of interest, ranging from $F_{low}$ to $F_{high}$,
- providing a sample (108) having at least an amorphous part,
- positioning the sample in the sample plane,
- irradiating an amorphous part of the sample with the parallel or almost parallel beam, thus forming a diffraction pattern of the amorphous part of the sample on the phase plate,
- while irradiating the sample, repeatedly:

  o record an image, and
  o estimate the sample spatial frequency dependent Radially Averaged Power Spectrum, RAPS(k), of the image, and
  ∘ estimate the integral of RAPS(k), ∫RAPS(k)dk, integrated over the sample spatial frequency range of interest,

- until ∫RAPS(k)dk is larger than a first predetermined value for ∫RAPS(k)dk, in which case the irradiation is terminated and the conditioning is a successful conditioning, or
- until the conditioning takes too long or the change of ∫RAPS(k)dk between successive images is below a predetermined minimum value, in which case the irradiation is terminated and the conditioning is an unsuccessful conditioning.

Inventors had the insight that when an amorphous sample is placed in the sample plane and said sample is imaged on a detector in the imaging plane of the TEM, a focused spot is formed on the HFPP (by the undiffracted beam) thus conditioning the HFPP. Simultaneously the image formed on the image plane (by the interference between the undiffracted beam and all diffracted electrons) is an image ideally comprising all sample spatial frequencies k (alike white noise as the sample is an amorphous sample) and thus the sample spatial frequency dependent Radially Averaged Power Spectrum (RAPS) for all sample spatial frequencies k can be determined, or at least estimated.

It is noted that the RAPS shows a background noise contribution, predominantly caused by the shot-noise in the beam of electrons produced by the electron source. To eliminate this background noise contribution the RAPS can be normalized by dividing the RAPS by the background noise power spectrum. The background can, for example, be estimated by a first measurement without sample (so: only detecting current variations on the undiffracted beam). Hereby the normalized RAPS(k), the so-called $RAPS_{norm}(k)$, is found. This $RAPS_{norm}$, (or an estimate thereof) can be used instead of the RAPS. Where in this application RAPS is used, this equally applies to $RAPS_{norm}$.

The RAPS(k) can be written as:

$$RAPS(k) = \sqrt{I(k)^2 + N(k)^2}$$

with k the sample spatial frequency, N(k) the noise and I(k)= 2σF(k) x CTF(k) x E(k) x MTF(k), with σ a constant, F(k) the structure factor of the specimen (the amorphous sample), CFT(k) represents the Contrast Transfer Function, E(k) represents the (microscope dependent) Envelope function, and MTF(k) represents the camera response function.

The RAPS is very sensitive to the value of the |CTF| at each spatial frequency (-assuming that E(k) is sufficiently large and there is sufficient structural information from the sample-) and an integrated value of RAPS (or the $RAPS_{norm}$) in a sample spatial frequency range of interest is a good measure of the contrast transfer in the sample spatial frequency range of interest (which may differ from k = 0, so may not include the lowest possible spatial frequencies). The RAPS can now be optimized by determining when the integrated value is beyond a predetermined value, indicating that an optimum in the phase shift is realized in the phase plate: the phase shift thus being close to $-\pi/2$ or close to $+\pi/2$ for weak phase objects.

When said predetermined value is reached, the irradiation is terminated, either by human intervention or automatically by a controller with appropriate programming.

It is noted that this optimum may not be the maximum phase shift attainable with prolonged conditioning, but corresponds with a phase shift close to $-\pi/2$ or close to $+\pi/2$, causing a maximum of the contrast transfer.

It is expressly noted that this method thus allows optimization contrast transfer for any spatial frequency and that the criterion used to end the conditioning is not a desired phase shift, but a desired improvement in contrast transfer. In this it differs from the method described by Malac et al., where the resultant value is the maximum attainable phase shift attained by prolonged irradiation of the HFPP, which need not coincide with the optimized contrast transfer for a desired spatial frequency band.

It is further noted that if the conditioning does not reach the desired value of ∫RAPS(k)dk the irradiation can be ended as well, flagging that the conditioning was an unsuccessful conditioning. The decision that the conditioning was unsuccessful can be based on the overall time spend on conditioning or on too little progress (too little improvement of RAPS(k) between successive images) such that it can be assumed that the desired value of ∫RAPS(k)dk will not be reached. This can be an automated decision or based on human intervention.

It is mentioned that typically the total electron dose used for conditioning is much larger than the electron dose used for normal imaging of a biological sample, even for imaging for a prolonged time (many images and/or imaging many samples and/or imaging many sample positions). Therefore the condition of the HFPP is hardly influenced by normal imaging, while the conditioning is done in a relatively short interval of time. However, also during conditioning an image is formed, and thus the progress of the conditioning can be observed 'on the fly'. Based on the progress an estimate of the RAPS for the spatial frequency range of interest can be made.

It is noted that the RAPS can be determined for a spatial frequency range, or for a single spatial frequency.

It is further noted that the RAPS can be estimated by using a mathematical method from the group of Radially Averaged Discrete Fourier Transform, Radially Averaged Fast Fourier Transform, and Radially Averaged Blackman-Tukey Method of Power Spectrum.

The spatial frequency range of interest may or may not border to the zero frequency ($F_{low} \rightarrow 0$).

The optimum used may be the spatial zero frequency (infinite large structures, or 'very large' structures), but may alternatively be a spatial frequency of, for example, $200/\mu m$, or a spatial frequency range between $150/\mu m$ and $200/\mu m$ or any other value and/or range, depending on sample, microscope and defocus used.

In an embodiment the spatial frequency range is a single spatial frequency, in which case the integral of RAPS(k) reduces (degrades) to RAPS(k).

In yet another embodiment of the method the Transmission Electron Microscope further comprises a signal processor, said signal processor acquiring the images, estimating the RAPS and deciding on terminating the irradiation.

This embodiment enables automatic conditioning of a HFPP. The signal processor, or controller, can determine the RAPS and decide on termination, as well as actually terminate the process.

In still another embodiment at least the RAPS for the spatial frequency range of interest is displayed on a display unit.

Displaying RAPS (or $RAPS_{norm}$) for a spatial frequency range (either the range of interest or a much larger range) enables an operator of the apparatus to observe progress, enabling intervention based thereon.

In still another embodiment a logging of the RAPS for the spatial frequency range versus time is displayed on a display unit.

By displaying a logging, the progress of the conditioning is displayed.

In still another embodiment a static graph is displayed on a display unit, the static graph showing the RAPS of an image obtained without phase plate and with sufficiently large defocus, and at least a part of the RAPS is displayed on a display unit. Preferably this is at least the part for frequencies below $F_{high}$. The defocus is chosen such that the RAPS shows a large number of oscillations (typically 10) and does not show an increase in the fall-off of the spatial coherence envelope function E(k).

A static graph of the spatial frequencies of an image obtained without phase plate and using large defocus shows peaks that correspond with the maximum attainable value of the RAPS that can be attained with a phase plate at the spatial frequencies corresponding with those peaks (even slightly more, as the phase plate itself scatters some electrons away, and thus the maximum signal in the image plane is slightly reduced, typically some 10-20%). Care must be taken that the defocus is not too large, as a large defocus also reduces the envelope function and thus the RAPS.

Thus the defocus RAPS can be used to make a good estimate of the RAPS that can be achieved with phase plate and to determine a value for the integral of the RAPS with phase plate in a frequency regime of interest.

In yet another embodiment the totally accumulated dose used for conditioning is registered and used at a later moment for conditioning the thin film at another position. In this case it is not needed to monitor the RAPS during the conditioning, it can be assumed that a similar dose can be used to get an optimal phase shift of the phase plate.

After using a HFPP for a while, the HFPP will deteriorate. As there is a large surface area on a thin film, it is attractive to laterally displace the thin film and form a conditioned spot at another position of the thin film (but still at the optical axis). By repeating the conditioning on said other location simply by exposing the newly centered part of the thin film to the same dose as used on the original location, the conditioning is a simple and time efficient process.

In an aspect of the invention a TEM equipped with

- an electron source for producing a beam of electrons,
- a sample plane,
- a condenser system for forming a parallel beam of electrons in the sample plane,
- an objective lens,
- a hole-free phase plate positioned in the back-focal plane of the objective lens or an image of said plane,
- an imaging system for forming an image of the sample plane or the back-focal plane of the objective lens on an image plane
- a detector in the image plane for acquiring images of the image plane,
- a programmable signal processor for processor the signal of the detector, and
- a display unit,

is characterized in that
the signal processor is programmed to perform the method according to any of the preceding methods according to the invention.

This aspect describes an apparatus equipped to automatically perform the conditioning of a HFPP.

**Brief description of the drawings**

The invention will now be elucidated in more detail on the basis of exemplary embodiments and the accompanying schematic drawings, in which:

Figure 1 schematically shows a TEM 100 equipped with a phase plate,
Figure 2 schematically shows a hole-free thin film phase plate,
Figure 3 schematically shows the potential of the thin film after irradiation,

Figure 4 schematically shows a workflow for operating a TEM equipped with a HFPP,
Figure 5 schematically shows the RAPS(k) of a defocused image without HFPP, and
Figure 6 schematically shows the $RAPS_{norm}$ (k) of a focused image of an amorphous sample using HFPP.

**Detailed description of the drawings**

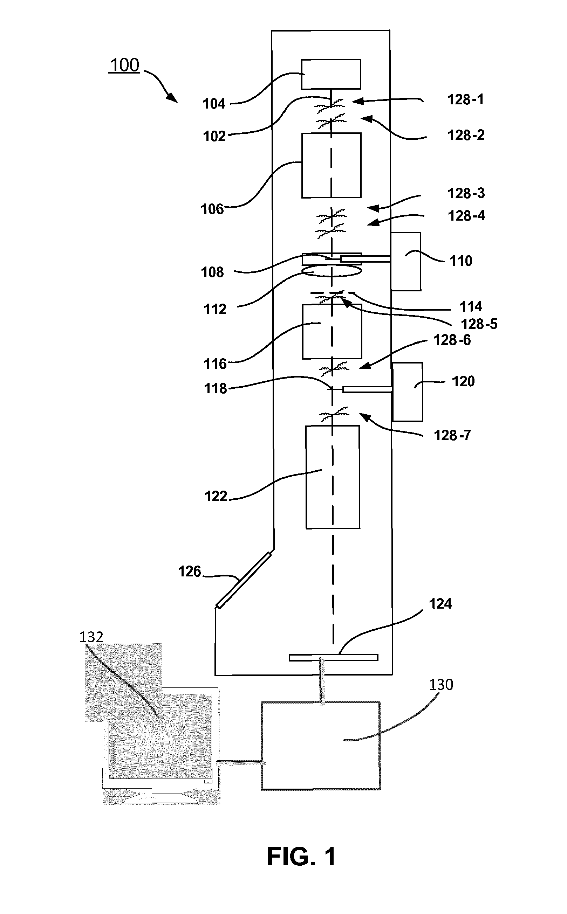

Figure 1 schematically shows a TEM 100 equipped with a HFPP.

Figure 1 shows a particle source 104 producing a beam of particles, such as electrons, along optical axis 102. The particles have a selectable energy of typically between 80 - 300 keV, although higher energies, e.g. 400 keV - 1 MeV, or lower energies, e.g. 50 keV, may be used. The beam of particles is manipulated by condenser system 106 to form a parallel beam impinging on a sample 108, the sample positioned with a sample holder 110. The sample holder can position the sample with respect to the optical axis and may shift the sample in the plane perpendicular to the optical axis and tilt the sample with respect to said axis. Objective lens 112 forms a magnified image of the sample. The objective lens is followed by a magnifying system 116, e.g. a doublet of lenses, forming an enlarged image of the back-focal plane 114 of the objective lens. A HFPP 118 is placed in the enlarged image of the back-focal plane of the objective lens, this conjugated plane positioned between the magnifying system and a projection system 122. The HFPP is positioned with a manipulator 120, allowing the HFPP to be centered round the optical axis. The projection system forms a magnified image of the sample on a detector 124, thereby revealing sample details of e.g. 1 nm. The detector may take the form of a fluorescent screen, or e.g. a CCD or CMOS camera. In the case of e.g. a fluorescent screen the screen can be viewed via the glass window 126.
To align the optical components on the axis the TEM comprises a large number of deflectors, schematically shown as 128-1..128-7, although other deflectors on other places may be included.

A controller/data processor 130 is connected to, among others, the detector to record images. The controller may process data for displaying, but may also process the data to represent/determine the RAPS. The detector is in turn connected to a monitor (132), and can display on said monitor for example images as acquired from the detector, showing an enlarged image of the sample or an enlarged image of the diffraction plane, or it may show the RAPS.

It is noted that the HFPP may also be positioned in the back-focal plane itself, in which case the magnifying system 116 is superfluous.

The HFPP is normally formed as a thin film surrounded by a holder structure, for example a platinum aperture as commonly used in electron microscopy.

Forming the phase plate with such an aperture has as an advantage that a standard aperture holder can be used to hold and position the HFPP. It is noted that heated aperture holders are known, the heating used to avoid contamination of the HFPP.

By now exposing the thin film to a large dose of energetic electrons, for example 200 keV electrons, a change in the electronic structure of the film surface or bulk material will occur, resulting in a difference in work function between irradiated area and non-irradiated area. As a result, an electrostatic potential will establish on the irradiated area, usually referred to as a Volta potential.

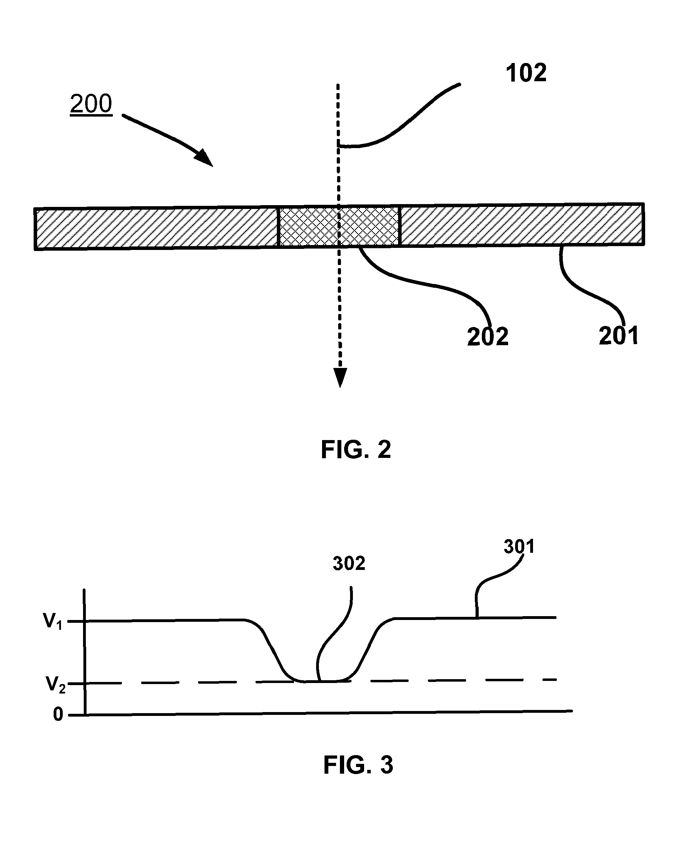

Figure 2 schematically shows the thin film of the thin film HFPP 200 that is irradiated in an area surrounding the axis 102 of the electron microscope. As a result the electronic structure of the area 202 is changed, while that of the non-irradiated area 201 is unchanged.

Figure 3 schematically shows the potential of the thin film HFPP after irradiation. Removed from the axis the potential equals the chemical potential, but the irradiated area has an added (negative) electronic potential.

Undiffracted electrons, travelling towards and through the irradiated part 202 of the thin film, experience less acceleration than diffracted electrons travelling through other parts of the thin film, as $V_2$ is less than $V_1$. This causes a positive phase contrast when the beams interfere in the image plane to form an image.

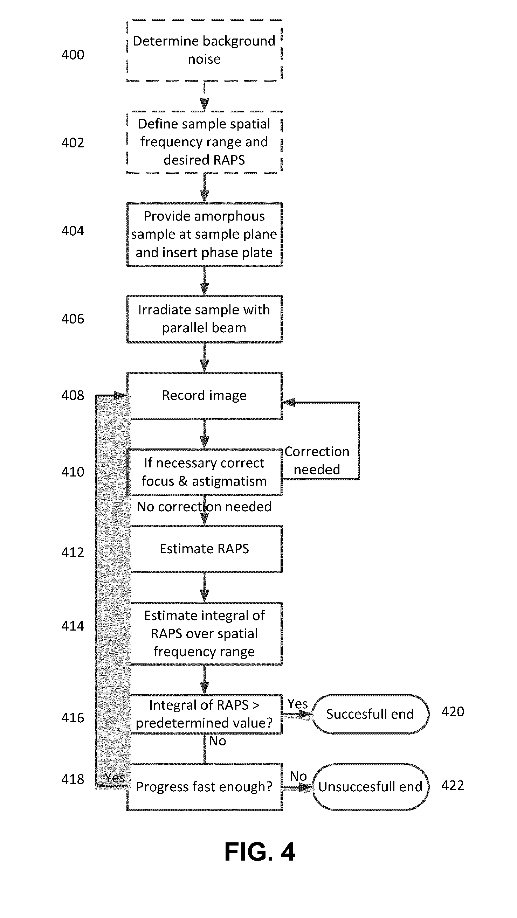

Figure 4 schematically shows a workflow for operating a transmission electron microscope equipped with a phase plate according to the invention.

Step 400: preferably the method starts with the determination of the background noise of the images for future normalization of the RAPS. This is done without a sample in the sample plane and by recording an image. The image will show predominantly shot-noise of the beam, as well as noise of the detector and the effect of the detector response function (noise transfer function). This noise image is independent of sample, so even if several spots on a HFPP and/or more than one HFPP are prepared, this step needs to be done only once. Such background curves can be collected both with and without phase plate in the back focal plane.

Step 402: in this step a sample spatial frequency range and a desired RAPS or integrated RAPS, $\int$JRAPS(k)dk, are defined.

To get rid of the erratic behavior near frequency '0' and the lack of information at high spatial frequencies it is preferred to determine the $\int$RAPS(k)dk in a frequency range of, for example, $F_{low}$ = 5% to $F_{high}$ = 75% of the Nyquist frequency of the detector.

As an alternative optimization of contrast can be performed for one frequency, in which case $\int$RAPS(k)dk reduces to RAPS(k) and this value of RAPS(k) is optimized.

It is noted that typically this is done only once if several spots on a HFPP and/or more than one HFPP are prepared.

Step 404: in this step the amorphous sample (or at least the sample with amorphous areas) is inserted in the microscope in the sample plane, brought into focus, and the astigmatism is minimized. In this step also the (unconditioned) phase plate is inserted into the microscope.

Step 406: in this step the conditioning starts.

Step 408: in this step an image is recorded.

Step 410: in this step the image just recorded is used to determine if the sample is still in focus and if any astigmatism occurs. If not, this is corrected and a new image is taken (back to step 408).

Step 412: in this step the RAPS (or RAPS$_{norm}$) is estimated.

Step 414: in this step the RAPS is integrated from $F_{low}$ to $F_{high}$.

Step 416: in this step it is determined if the $\int$RAPS(k)dk (or the RAPS(k) when only one frequency is used) is equal to or exceeds the predetermined desired value of $\int$RAPS(k)dk (defined in step 402). If so, the conditioning is interrupted and the conditioning ended successfully (step 420).

Step 418: in this step it is determined if the progress of increase of $\int$RAPS(k)dk is sufficient in a stage where the predetermined value is not yet reached. This can be determined in at least two ways: simplest is to look at the elapsed time, another method is looking at the progress of RAPS determined between successive images.

If it takes too long, the process can be ended flagging that the conditioning ended unsuccessful (step 422).If there is sufficient progress the process is re-iterated (step 408).

It is noted that the conditioning can be interrupted by human intervention or by a controller forming part of (or at least connected to) the microscope.

When ending the process (either steps 420 or 422) the irradiation, that started in step 406, is ended and the TEM is set to normal operation with a HFPP (and operated with a much smaller beam current).

It is noted that, as is clear to the skilled artisan, these steps can be executed in a slightly different way, or in a different order. For example the focusing mentioned in step 410 can take place before steps 412 and 414, or afterwards, or even in time overlapping with these steps. Progress of the RAPS can be displayed for each image, or the integral thereof for a frequency band can be displayed, or plotted against time. Also steps 416 and 418 (and corresponding steps 420 and 422) can be exchanged. Many variations are possible.

Note that after execution of this workflow, a number can be determined for the total electron dose needed for conditioning of the phase plate. When addressing a new area on the phase plate it can be decided to use this pre-determined conditioning dose without further inspection/modification instead of again going through the conditioning workflow.

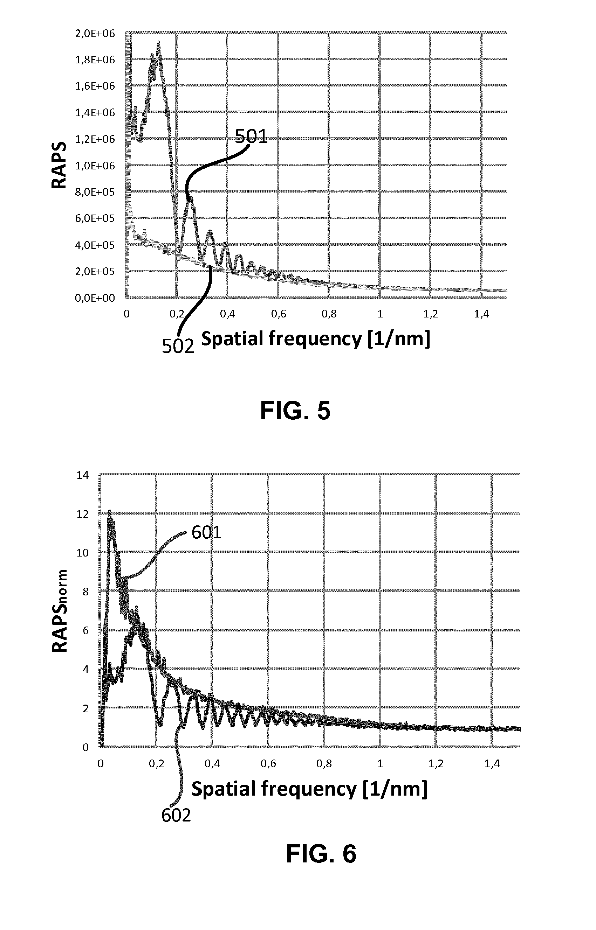

Figure 5 schematically shows the RAPS obtained from a defocused image without the use of a HFPP.

Curve 501 shows the RAPS as a function of the sample spatial frequency in which the beam impinges on a sample, making a defocused image. Curve 501 is an oscillatory function.

Curve 502 shows the background noise by showing the RAPS of an empty image, that is: an image without sample inserted.

The integration interval can be chosen from spatial frequency 0 up to the Nyquist frequency of the detector. No contrast improvement is expected for the very lowest frequencies, so it is better to exclude the DC component (0/nm) and low frequencies (0-5% of the Nyquist frequency)

It is noted that the tops of curve 501 represents the RAPS with the maximum |CTF| that can be obtained, and is thus also the maximum RAPS that can be obtained. As the curve is obtained without HFPP, these tops are even slightly higher than can be obtained with a HFPP, as in reality a HFPP always scatters some electrons out of the beam, thereby slightly lowering the |CTF|.

It is noted that curve 501 ideally should touch curve 502 in its minima, but due to, for example, slight astigmatism or coma, this may not be the case.

Figure 6 schematically shows the normalized $RAPS_{norm}$ with an amorphous sample and a HFPP.

Curve 601 shows the $RAPS_{norm}$ derived from an amorphous sample and use of the HFPP. As the curve is recorded in focus, the curve does not show an oscillatory function. Curve 602 is the normalized version of curve 501 as shown in figure 5, obtained without HFPP. Here again the maxima of curve 602 correspond to the maxima that can be obtained for curve 601. When the image of the sample is free from astigmatism and coma, the curve 602 should have unity (the value 1) as base line.

It is noted that when the flowchart of figure 4 is successfully ended, a numerical improvement factor of the contrast (in the sample spatial frequency range of interest) can be displayed.

**Cited non-patent literature**

[-1-] Nagayama K et al., 'Phase Contrast Enhancement with Phase Plates in Biological Electron Microscopy', Microscopy Today, July 2010, Vol. 18, No. 4 (July 2010), pages 10-13.

[-2-] Johnson HM, 'Chapter 4: In-focus phase contrast electron microscopy', in 'Principles and Techniques of Electron Microscopy, Vol. 3: Biological applications', Ed. M.A. Hayat, ISBN- 0-442-25674-4, pages 174-176.

**Claims**

1. A method of conditioning a hole-free phase plate in a Transmission Electron Microscope (100), the Transmission Electron Microscope comprising:

   • an electron source (104) for producing a beam of electrons,
   • a sample plane,
   • a condenser system (106) for forming a parallel or almost parallel beam of electrons on the sample plane,
   • an objective lens (112) for focusing the parallel or almost parallel beam at a diffraction plane,
   • a hole-free phase plate positioned in the diffraction plane or an plane conjugated thereto,
   • an imaging system (116 + 118) for forming an enlarged image of the sample plane or the diffraction plane onto an image plane,
   • a detector (124) in the image plane for recording images of the image plane the method **characterized in that** the method comprises:
   • define a sample spatial frequency range of interest, ranging from $F_{low}$ to $F_{high}$
   • providing a sample (108) having at least an amorphous part,
   • positioning the sample in the sample plane,
   • irradiating an amorphous part of the sample with the parallel or almost parallel beam, thus forming a diffraction pattern of the amorphous part of the sample on the phase plate,
   • while irradiating the sample, repeatedly:

      o record an image,
      o estimate the sample spatial frequency dependent Radially Averaged Power Spectrum, RAPS(k), of the image
      o estimate the integral of RAPS(k), ∫JRAPS(k)dk, integrated over the sample spatial frequency range of interest,

   • until ∫RAPS(k)dk is larger than a first predetermined value for ∫RAPS(k)dk, in which case the irradiation is terminated and the conditioning is a successful conditioning, or
   • until the progress in conditioning is too slow or the change of ∫RAPS(k)dk between successive images is below a predetermined minimum value, and the irradiation is terminated and the conditioning is an unsuccessful conditioning.

2. The method of the preceding claim in $F_{low}$ borders the frequency zero.

3. The method of the claim 1 in which $F_{low}$ does not border the frequency zero.

4. The method of any of the preceding claims in which the spatial frequency range is a single spatial frequency, and ∫RAPS(k)dk reduces to RAPS(k)

5. The method of any of the preceding claims in which the |CTF| is estimated by performing an arithmetic operation on the acquired image, the arithmetic operation comprising an operation from the group of Radially Averaged Discrete Fourier Transform, Radially Averaged Fast Fourier Transform, and Radially Averaged Blackman-Tukey Method of Power Spectrum.

6. The method of any of the preceding claims in which the ending of the irradiation is an ending by human intervention.

7. The method of any of claims 1-5 in which the Transmission Electron Microscope further comprises a signal processor, said signal processor acquiring the images, estimating the integral of RAPS(k), and deciding on termination of the irradiation.

8. The method of any of the preceding claims in which at least an estimate of the integral of the RAPS(k) or an estimate of the integral of the |CTF| for the sample spatial frequency range of interest is displayed on a display unit.

9. The method of any of the preceding claims in which a logging of the estimate of the integral of RAPS(k) or the estimate of the integral of the integral of |CTF| for the sample spatial frequency range versus time is displayed.

10. The method of any of the preceding claims in which a static graph is displayed on a display unit, the static graph showing the spatial frequencies of an image obtained without phase plate and with large defocus, and at least a part of the estimate of RAPS(k) or the low-frequency part of the estimate of |CTF| is displayed on the display unit.

11. The method of any of the preceding claims, in which the dose used for conditioning is registered and used at a later moment for conditioning the thin film at another position.

12. A Transmission Electron Microscope (100) equipped with

   • an electron source (104) for producing a beam of electrons,
   • a condenser system (106) for forming a parallel beam of electrons on a sample plane,
   • an objective lens (112),
   • a hole-free phase plate (118) positioned in the back-focal plane of the objective lens or an image of said plane,

   • an imaging system (116 + 122) for forming an enlarged image of the sample plane or the back-focal plane of the objective lens on an image plane
   • a detector (124) in the image plane for acquiring images of the image plane,
   • a programmable signal processor (130) for processing the signal of the detector, and
   • a display unit (132),
   **characterized in that**
   the programmable signal processor is programmed to perform the method according to any of the preceding claims.

**FIG. 1**

200

102

202

201

**FIG. 2**

301

302

$V_1$

$V_2$

0

**FIG. 3**

400 — Determine background noise

402 — Define sample spatial frequency range and desired RAPS

404 — Provide amorphous sample at sample plane and insert phase plate

406 — Irradiate sample with parallel beam

408 — Record image

410 — If necessary correct focus & astigmatism

Correction needed

No correction needed

412 — Estimate RAPS

414 — Estimate integral of RAPS over spatial frequency range

416 — Integral of RAPS > predetermined value?

Yes

420 — Succesfull end

No

418 — Progress fast enough?

Yes

No

422 — Unsuccesfull end

**FIG. 4**

**FIG. 5**

**FIG. 6**

Europäisches
Patentamt

European
Patent Office

Office européen
des brevets

# EUROPEAN SEARCH REPORT

Application Number

EP 14 18 7878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAREK MALAC ET AL: "Convenient contrast enhancement by a hole-free phase plate", ULTRAMICROSCOPY, ELSEVIER, AMSTERDAM, NL, vol. 118, 19 February 2012 (2012-02-19), pages 77-89, XP028405472, ISSN: 0304-3991, DOI: 10.1016/J.ULTRAMIC.2012.02.004 [retrieved on 2012-03-05] * abstract * * page 77 - page 84; figures 3, 5, 7-11 * | 1-12 | INV. H01J37/26 |
| A | MAREK MALAC ET AL: "Charging of Thin Film Phase plates under Electron Beam Irradiation", MICROSCOPY AND MICROANALYSIS, SPRINGER, NEW YORK, NY, US, vol. 20, no. S3, 1 August 2014 (2014-08-01), pages 230-231, XP009183108, ISSN: 1431-9276 * the whole document * | 1-12 | |
| A | KRASSIMIR DANOV ET AL: "Electric charging of thin films measured using the contrast transfer function", ULTRAMICROSCOPY, vol. 87, no. 1-2, 1 March 2001 (2001-03-01), pages 45-54, XP055175235, ISSN: 0304-3991, DOI: 10.1016/S0304-3991(00)00061-9 * the whole document * | 1-12 | TECHNICAL FIELDS SEARCHED (IPC) H01J |

The present search report has been drawn up for all claims

| Place of search | Date of completion of the search | Examiner |
|---|---|---|
| Munich | 12 March 2015 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110174971 A1, Malac

- EP 14165529 A1, Buijsse


**Non-patent literature cited in the description**

- **NAGAYAMA K et al.** Phase Contrast Enhancement with Phase Plates in Biological Electron Microscopy. *Microscopy Today,* July 2010, vol. 18 (4), 10-13

- Chapter 4: In-focus phase contrast electron microscopy. **JOHNSON HM.** Principles and Techniques of Electron Microscopy, Vol. 3: Biological applications. vol. 3, 174-176
- **NAGAYAMA K et al.** Phase Contrast Enhancement with Phase Plates in Biological Electron Microscopy. *Microscopy Today,* July 2010, vol. 18, 10-13